# EUROPEAN PATENT APPLICATION

(11) **EP 3 945 521 A1**
(43) Date of publication of application: **02.02.2022**
(21) Application number: 20315371.3
(22) Date of filing: 30.07.2020
(51) Int. Cl.: G11C 11/16

(54) **MAGNETIC RANDOM ACCESS MEMORY CELL AND METHOD FOR READING SAID CELL**

(71) Applicant: Antaios, 38240 Meylan (FR)
(72) Inventor: Martin, Sylvain, 38100 Grenoble (FR); Louche, Julien, 38950 Saint-Martin-le-Vinoux (FR)
(74) Representative: P&TS SA (AG, Ltd.)

(57) **Abstract**

A MRAM cell (100), comprising a first and second MTJ elements (10, 11), each comprising a ferromagnetic layer (23) having a magnetization (230); a write current line (30) and a junction current line (35) contacting, respectively, a first end and a second end of the MTJ elements (10, 11); a second bit line (BL2) and a third bit line (BL3) connecting both ends of the write current line (30). The MRAM cell (100) further comprises a single read transistor (41) connected to a first bit line (BL1) and a single write transistor (42) connected to the second bit line (BL2). The read transistor (41) can be set in a closed mode and the write transistor (42) can be set in a passing mode, allowing a write current (31) to flow in the write current line (30) and switch the magnetization (230) of the MTJ elements (10, 11). The read and write transistors (41, 42) can be set in a passing mode, allowing a first and second read current (32, 34) to flow in the first and second MTJ element (10, 11), respectively.

## Description

### Technical domain

The present invention concerns a magnetic random access memory (MRAM) cell and a magnetic memory comprising a plurality of MRAM cells. The present invention further concerns a method for reading the MRAM cell. In particular, the present invention concerns a MRAM cell that can be written using a spin orbit torque (SOT) interaction and a magnetic memory having a high density of MRAM cell.

### Related art

A conventional MRAM cell comprises a magnetic tunnel junction (MTJ) element including a tunnel barrier layer sandwiched between a first ferromagnetic layer having a first magnetization, and a second ferromagnetic layer having a second magnetization. In order to determine the magnetic state of the MTJ element, i.e., if the first magnetization is antiparallel to the second magnetization (magnetic state "1") or if the first magnetization is parallel to the second magnetization (magnetic state "0"), a measured resistance of the MTJ element must be compared to a reference.

A differential MRAM cell comprises two MTJ elements, wherein the first magnetization of one of the MRAM cells is oriented in a first direction and the first magnetization of the other MRAM cell is oriented in a second direction opposed to the first direction. In a differential MRAM cell, the magnetic state of the MTJ elements can be determined by measuring a difference between a signal from one of the MTJ elements and the other. In a differential MRAM cell, the two MTJ elements can be written in the two opposite magnetic states using a single write current or two different currents. It is then possible to compare the state of the two MTJ elements during a read operation.

In conventional differential bit cell, resistances of the two MTJs can be read separately.

A conventional differential bit cell generally comprises 3 transistors and 2 magnetoresistive MTJ elements (3T2R). One transistor is connected to the word line used for writing to the differential bit cell and one transistor for each bit line addressing each magnetoresistive element during a reading operation. In order to assess the state of the cell ("0" or "1") one compares the reading current respectively passing through each of the MTJ elements.

### Summary

The present disclosure concerns a MRAM cell comprising a first and second MTJ element, each comprising a tunnel barrier layer between a first ferromagnetic layer having a first magnetization and a second ferromagnetic layer having a second magnetization; a write current line in electrical contact with a first end of the MTJ elements and configured to pass a write current adapted for switching a second magnetization. The MRAM cell further comprises a first bit line, a second bit line connecting one end of the write current line and a third bit line connecting the other end of the current line. The MRAM cell comprises a single read transistor connected to the first bit line, a single write transistor connected to the second bit line and a junction current line connecting a second end of the two MTJ elements and the first bit line, such that during a write operation, the read transistor and the write transistor can be set respectively in a closed and passing mode, allowing the write current to flow in the write current line via the second and third bit lines and switch the second magnetization of the first and second MTJ elements; and during a read operation, the read and write transistors can be set in a passing mode, allowing a first read current to flow in the first MTJ element and a second read current to flow in the second MTJ element via the second bit line, junction current line and first bit line.

In an embodiment, the MRAM cell has a differential configuration such that the write current can switch the second magnetization of the first MTJ element in a first direction and switch the second magnetization of the second MTJ element in a second direction opposed to the first direction.

In an embodiment, the write current line is configured to generate a spin current such that the write current is adapted for switching the second magnetization by a SOT interaction.

The present disclosure further concerns a magnetic memory comprising a plurality of the MRAM cells and a magnetic memory device comprising the magnetic memory and a control module connected to the MRAM cells.

The present disclosure also pertains to a method for reading the MRAM cell.

With respect to what is known in the art, the invention provides the advantage that the MRAM cell comprises only two transistors instead of three. The magnetic memory can have a density of MRAM cells up to 30% higher than for a conventional magnetic memory.

### Short description of the drawings

Exemplar embodiments of the invention are disclosed in the description and illustrated by the drawings in which:
Fig. 1 shows a MRAM cell comprising two MTJ elements, according to an embodiment;
Fig. 2 shows a detail of a MTJ element;
Fig. 3 shows a side view of the MRAM cell 100 in a differential configuration, according to an embodiment;
Fig. 4 shows the MRAM cell during a write operation, according to an embodiment;
Fig. 5 shows the MRAM cell during a read operation, according to an embodiment;
Fig. 6 shows a top view of a magnetic memory comprising a plurality of MRAM cells, according to an embodiment;
Fig. 7 illustrates the magnetic memory comprising a complementary transistor, according to an embodiment; and
Fig. 8 illustrates the MRAM cell connected to a read sub-module.

### Examples of embodiments

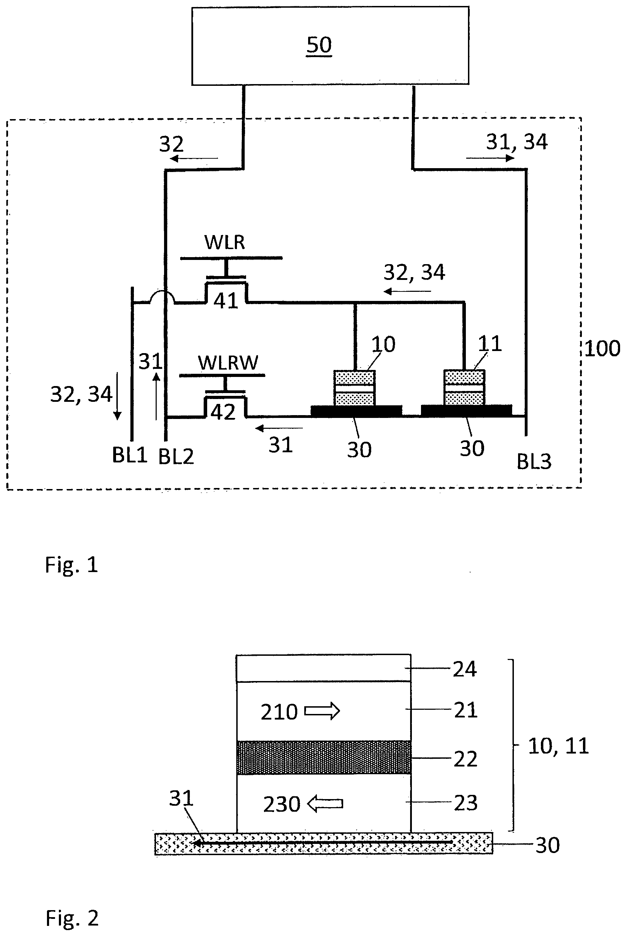

Fig. 1 shows a MRAM cell 100, according to an embodiment. The MRAM cell 100 comprises a first MTJ element 10 and a second MTJ element 11. As illustrated in Fig. 2, each MTJ element 10, 11 comprises a tunnel barrier layer 22 sandwiched between a first ferromagnetic layer 21 having a first magnetization 210, and a second ferromagnetic layer 23 having a second magnetization 230. The first ferromagnetic layer 21 can comprise a pinned ferromagnetic layer having a pinned magnetization, for example pinned by an antiferromagnetic layer 24. The second ferromagnetic layer 23 can comprise a free layer having a free magnetization 230. Alternatively, the second ferromagnetic layer 23 can comprise a storage layer having a storage magnetization 230 pinned at a different threshold temperature than the first magnetization 210. Here, a threshold temperature can be a blocking temperature, a Neel temperature, or another threshold temperature. The first ferromagnetic layer 21 and the antiferromagnetic layer 24 can comprise a SAF structure including a metallic non-magnetic spacer layer and ferromagnetic layers.

A write current line 30 extends substantially parallel to the plane of the layers 21-23 and is in electrical contact with a first end of the MTJ elements 10, 11, for example on the side of the free layer 23. The write current line 30 connects the first MTJ element 10 in series to the second MTJ element 11.

The MRAM cell 100 further comprises a first bit line BL1 connected to a read transistor 41. A junction current line 35 connects a second end of the two MTJ elements 10, 11 to the read transistor 41. The junction current line 35 connects the first MTJ element 10 in parallel to the second MTJ element 11. A second bit line BL2 connects one end of the write current line 30 via a write transistor 42. The other end of the write current line 30 is connected to a third bit line BL3. A read word line WLR connects the gate of the read transistor 41. A write word line WLRW connects the gate of the write transistor 42. The MRAM cell 100 of Fig. 1 comprises a single read transistor 41 and a single the write transistor 42. Such cell can also be referred to as a two-transistor and two-MTJ (2T2R) configuration.

The MRAM cell 100 is configured to be connected to a control module 50 that will be described below, via the second bit line BL2 and the third bit line BL3.

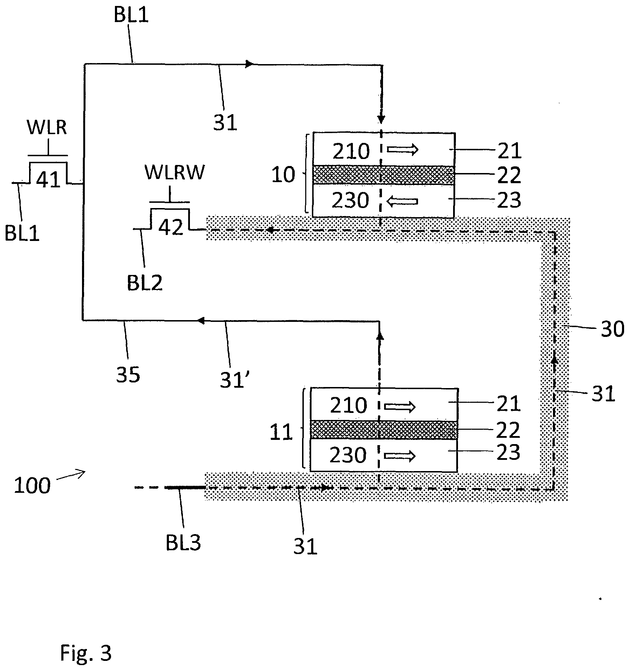

In a preferred embodiment, the MRAM cell 100 has a differential configuration such that the write current 31 can switch the second magnetization 230 of the first MTJ element 10 in a first direction and switch the second magnetization 230 of the second MTJ element 11 in a second direction opposed to the first direction. Fig. 3 shows a side view of the MRAM cell 100 according to an embodiment, wherein the differential configuration is achieved by the write current line 30 having a U shape configuration. As shown in Fig. 3, the U-shaped write current line 30 connects the first end of the MTJ elements 10, 11. The junction current line 35 connects the second end of the first and second MTJ elements 10, 11. Due to the U-shape configuration, a write current 31 flows in the write current line 30 with opposed polarity relative to the first magnetization 210 of the first and second MTJ elements 10, 11.

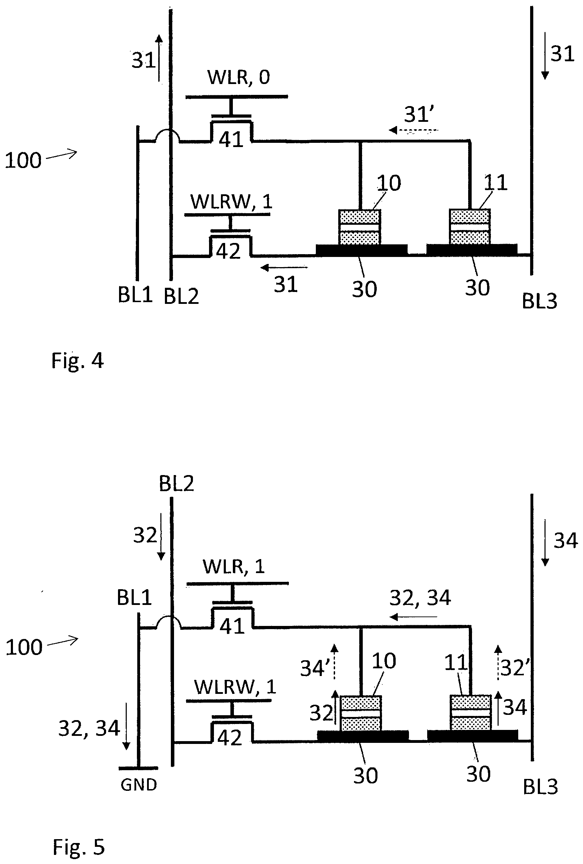

Fig. 4 shows the MRAM cell 100 during a write operation. During the write operation, the write word line WLRW is biased to "1" such as to control the write transistor 42 in a passing mode. The read word line WLR is biased to "0" to control the read transistor 41 in a closed mode. This configuration allows for a write current 31 to flow in the write current line 30 via the second and third bit lines BL2, BL3. The write current 31 is adapted for switching the second magnetization 230 of the first and second MTJ elements 10, 11.

In one aspect, the write current 31 is adapted for switching the second magnetization 230 by a spin orbit torque (SOT) interaction. To that end, the write current line 30 can be configured to generate a spin current, for example due to a spin Hall effect and/or Rashba-Edelstein effect, when the write current 31 flows therethrough. The write current line 30 can comprise any material configured to generate a spin current (for example a pure spin current). Such material is not limited to a material consisting of a single element and may be a conductive material which generates a spin current. More particularly, such material can include but are not limited to Pt, W, Ta, Ir, Ru, Pd, Cu, Au, Bi, Hf, Se, Sb or of an alloy of these elements.

Due to the differential configuration of the write current line 30, the write current 31 switches the second magnetization 230 of the first MTJ element 10 in a first direction, for example antiparallel to the first magnetization 210 (magnetic state "1"), and switches the second magnetization 230 of the second MTJ element 11 in a second direction opposed to the first direction, for example parallel to the first magnetization 210 (magnetic state "0").

Since the second end of the first and second MTJ elements 10, 11 are connected in parallel, during the write operation a portion 31' of the write current 31 flowing in the write current line 30 may also flow through the first and second MTJ elements 10, 11. Albeit only a small fraction of the write current 31, the write current portion 31' can facilitate the switching of the second magnetization 230 by exerting a spin transfer torque (STT) on the second magnetization 230. The write current portion 31' passing through the MTJ elements 10, 11 can further break the symmetry and provide deterministically switching of the second magnetization 230.

The write current 31 can be generated by the control module 50, for example by a write sub-module of the control module 50, when the latter is connected to the MRAM cell 100 via the second bit line BL2 and the third bit line BL3. In particular, the control module 50 can be configured to control the write word line WLRW to "1" such as to set the write transistor 42 in a passing mode, control the read word line WLR to "0" such as to set the read transistor 41 in a closed mode and inject the write current 31 in the second bit line BL2 and third bit line BL3.

With reference to Fig. 5, during a read operation, the read word line WLR and the write word line WLRW are biased to "1" such as to control respectively the read and write transistors 41, 42 in a passing mode. A first read current 32 is passed in the second bit line BL2. The first read current 32 flows in the second bit line BL2, through the second transistor 42 and the first MTJ element 10 and in the first bit line BL1 via the read transistor 41. The second read current 34 flows in the third bit line BL3, through the second MTJ element 11 and in the first bit line BL1 via the read transistor 41.

When passing through the first and second MTJ elements 10, 11, the first and second read currents 32, 34 generate, respectively, a first voltage V1 across the first MTJ element 10 and a second voltage V2 across the second MTJ element 11. The first voltage V1 corresponds to a first resistance R1 of the first MTJ element 10 and the second voltage V2 corresponds to a second resistance R2 of the second MTJ element 11.

The first resistance R1 of the first MTJ element 10 and the second resistance R2 of the second MTJ element 11 in turn depend on orientation of the second magnetization 230 relative to the first magnetization 210 in each of the first and second MTJ elements 10, 11. For example, if the second magnetization 230 is antiparallel to the first magnetization 210 (magnetic state "1") in the first MTJ element 10, the first resistance R1 is high. If the second magnetization 230 is parallel to the first magnetization 210 (magnetic state "0") in the second MTJ element 11, the resistance R2 is low.

Thus, the first and second resistances R1, R2, and thus the magnetic state, of the first and second MTJ elements 10, 11, can be determined by measuring the first read current 32 and the second read current 34 and by determining the difference between the first and second read currents 32, 34.

Since the first end of the first and second MTJ elements 10, 11 are connected to the write current line 30 and the second end of the first and second MTJ elements 10, 11 are connected to the junction current line 35, during the read operation a portion 32' of the first read current 32 may flow in the write current line 30 and through the second MTJ element 11. Similarly, a portion 34' of the second read current 34 may flow in the write current line 30 and through the first MTJ element 10. However, due to the electrical resistance of the write current line 30 and the high electrical resistance of the MTJ elements 10, 11, the first read current portion 32' and the second current portion 34' will be a small fraction of the first and second read currents 32, 34, respectively.

In one aspect, the MRAM cell 100 is configured such that the magnitude of the first read current portion 32' and the second current portion 34' is smaller than the magnitude of the first and second read currents 32, 34, respectively, such that the difference measured between the first and second MTJ elements 10, 11 being in the two different magnetic state "0" and "1" is greater than the difference when the first and second read current portion 32', 34' is null.

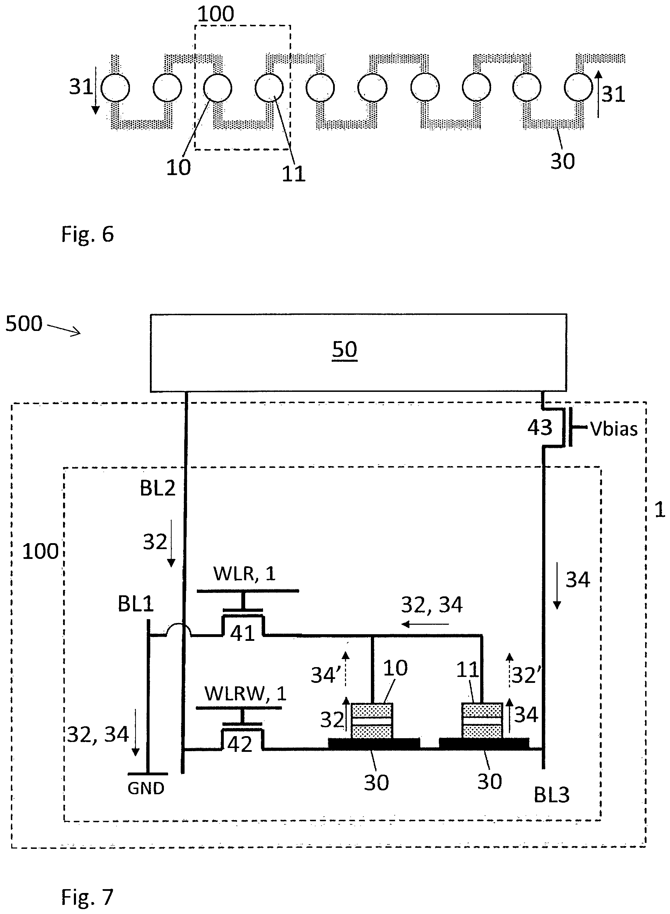

Fig. 6 show a top view of a magnetic memory 1 comprising a plurality of MRAM cells 100, according to an embodiment, wherein the MRAM cells 100 are connected via the write current line 30. In Fig. 6, the bit lines BL1, BL2, BL3 and the two transistors 41, 42 comprised in each MRAM cell 100 are not represented.

Since each MRAM cell 100 comprises only two transistors 41, 42, the real estate occupied by each MRAM cell 100 can be smaller and the than for a three-transistor MRAM cell. In other words, the 2T2R configuration of the MRAM cell 100 allows for a higher density of MTJ elements for a given real estate. The density increase of MTJ elements of the 2T2R configuration of the MRAM cell 100 can be about 30%.

In an embodiment illustrated in Fig. 7, the magnetic memory 1 comprises a complementary transistor 43 connected to the third bit line BL3 of the MRAM cells 100. During the read operation, the complementary transistor 43 is set in a passing mode drain, by providing a supply voltage Vbias at its gate, or an adjustable supply voltage that can be adjusted depending on the configuration of the write transistor 42, such that the second read current 34 passing in the third line BL3 provide a resistance (the resistance of the complementary transistor 43) in the second read current 34 path that counter balance the resistance of the write transistor 42 in the path of the first read current 32. This allows improving the symmetry between the path of the first and second read currents 32, 34 and thus, the determination of the first and second resistances R1, R2 from the difference between the first and second voltage V1, V2. Since only one complementary transistor 43 can be added in the magnetic memory 1 comprising a plurality of the MRAM cells 100, the real estate occupied by the complementary transistor 43 can be neglected.

The first and second read currents 32, 34 can be generated by the control module 50, for example by a read sub-module of the control module 50, when the latter is connected to the MRAM cell 100, and possibly the magnetic memory 1, via the first bit line BL1 and the third bit line BL3.

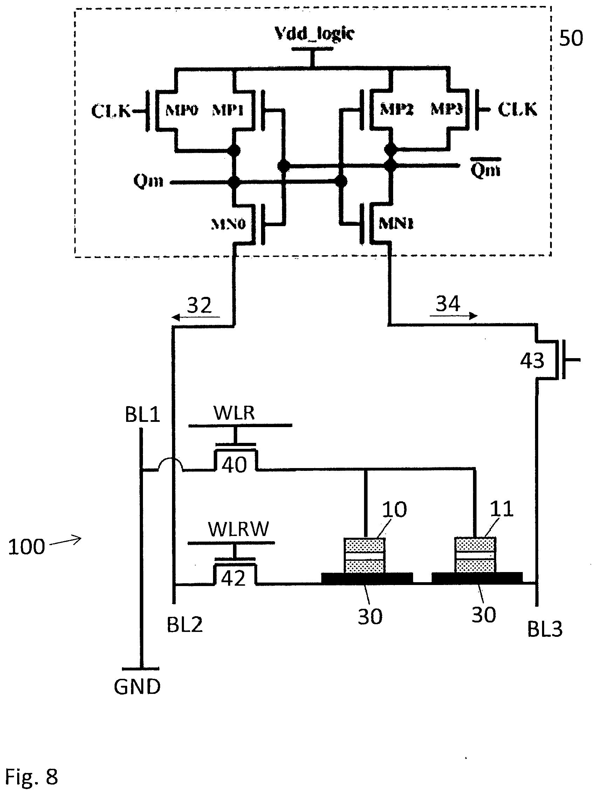

Fig. 8 illustrate the MRAM cell 100 being connected to the control module 50. Here, the control module 50 comprises a read sub-module including pre-charge sense amplifier (PCSA) such as the PCSA that has been proposed in Weisheng Zhao, et. al., "High speed, high stability and low power sensing amplifier for MTJ/CMOS hybrid logic circuits", IEEE Transaction on Magnetics, Vol. 45, October 2009, pp. 3784-3787. Such PCSA includes two inverters (MP0, MN0 and MP1, MN1), two PMOS transistors (MP2, MP3) in parallel with MP0 and MP1, respectively, and one NMOS transistor MN2 connecting the circuit with ground (GND). The PCSA uses two operating phases depending on the control signal SE. Other read sub-module configurations can be contemplated. In one aspect, identical currents can be applied to the second and third bit lines BL2 and BL3 to produce voltages according to the resistance of the MTJ elements 10, 11. The voltages are then compared by a sense amplifier to produce a digital output, see D. Goql at al., "A 16-Mb MRAM Featuring Bootstrapped Write Drivers," IEEE J. of Solid- State Circuits, Vol. 40, No. 4, pp. 902-908, Apr. 2005.

### Reference numbers and symbols

- 1: magnetic memory
- 10: first MTJ element
- 11: second MTJ element
- 100: MRAM cell
- 21: first ferromagnetic layer
- 210: first magnetization
- 22: tunnel barrier layer
- 23: second ferromagnetic layer
- 230: second magnetization
- 24: antiferromagnetic layer
- 30: write current line
- 31: write current
- 31': portion of the write current
- 32: first read current
- 34: second read current
- 32': portion of the first read current
- 34': portion of the second read current
- 35: junction current line
- 41: read transistor
- 42: write transistor
- 43: complementary transistor
- 50: control module
- 500: magnetic memory device

- BL1: first bit line
- BL2: second bit line
- BL3: third bit line
- R1: first resistance
- R2: second resistance
- V1: first voltage
- V2: second voltage
- WLR: read word line
- WLRW: write word line

## Claims

1. A magnetic random access memory (MRAM) cell (100), comprising:
A first magnetic tunnel junction (MTJ) element (10) and a second MTJ element (11), each MTJ element (10, 11) comprising a tunnel barrier layer (22) between a first ferromagnetic layer (21) having a first magnetization (210) and a second ferromagnetic layer (23) having a second magnetization (230);
a write current line (30) in electrical contact with a first end of the MTJ elements (10, 11) and configured to pass a write current (31) adapted for switching a second magnetization (230);
a first bit line (BL1);
a second bit line (BL2) connecting one end of the write current line (30);
a third bit line (BL3) connecting the other end of the write current line (30);
**characterized in that**
the MRAM cell (100) comprises a single read transistor (41) connected to the first bit line (BL1) and a single write transistor (42) connected to the second bit line (BL2); and a junction current line (35) connecting a second end of the two MTJ elements (10, 11) and the first bit line (BL1); such that
during a write operation, the read transistor (41) can be set in a closed mode and the write transistor (42) can be set in a passing mode, allowing the write current (31) to flow in the write current line (30) via the second and third bit lines (BL2, BL3) and switch the second magnetization (230) of the first and second MTJ elements (10, 11); and
during a read operation, the read and write transistors (41, 42) can be set in a passing mode, allowing a first read current (32) to flow in the first MTJ element (10) and a second read current (34) to flow in the second MTJ element (11) via the second bit line (BL2), junction current line (35) and first bit line (BL1).

2. The MRAM cell (100) according to claim 1,
having a differential configuration such that the write current (31) can switch the second magnetization (230) of the first MTJ element (10) in a first direction and switch the second magnetization (230) of the second MTJ element (11) in a second direction opposed to the first direction.

3. The MRAM cell (100) according to claim 2,
wherein the write current line (30) has a U shape configuration.

4. The MRAM cell (100) according to any one of claims 1 to 3,
wherein the write current line (30) is configured to generate a spin current such that the write current (31) is adapted for switching the second magnetization (230) by a spin orbit torque (SOT) interaction.

5. The MRAM cell (100) according to claim 4,
configured to let a portion (31') of the write current (31) to flow through the first and second MTJ elements (10, 11), wherein the write current portion (31') can break the symmetry and provide deterministically switching of the free magnetization (230).

6. The MRAM cell (100) according to any one of claims 1 to 5,
configured such that the magnitude of a first portion (32') of the first read current (32) flowing in the second MTJ element (11) and the magnitude of a second portion (34') of the second read current (34) flowing in the first MTJ element (10) is smaller than the magnitude of the first and second read currents (32, 34), respectively.

7. A magnetic memory (1) comprising a plurality of the MRAM cells (100) according to any one of claims 1 to 5.

8. The magnetic memory (1) according to claim 7,
comprises a complementary transistor (43) connected to the third bit line (BL3) of the MRAM cells (100).

9. A magnetic memory device (500) comprising the magnetic memory (1) according to claim 7 or 8 and a control module (50) connected to the second bit line (BL2) and the third bit line (BL3) of the MRAM cells (100),
wherein the control module (50) comprises a write sub-module configured, during the write operation, to set the read transistor (41) in a closed mode and the write transistor (42) in a passing mode and inject the write current (31) in the write current line (30); and
wherein the control module (50) comprises a read sub-module configured, during the read operation, to set the read and write transistors (41, 42) in a passing mode and inject the first read current (32) in the in the second bit line (BL2) and the second read current (34) in the third bit line (BL3).

10. The magnetic memory device (500) according to claim 9, further configured to measure a difference between a first voltage (V1) across the first MTJ element (10) and second voltage (V2) across the second MTJ element (11) when the first and second read currents (32, 34) flow through the first and second MTJ elements (10, 11), respectively; and
for determining the magnetic state of the first and second MTJ elements (10, 11) from said difference.

11. Method for reading the MRAM cell (100) according to any one of claims 1 to 6, comprising:
setting the write transistor (42) and the read transistor (42) in a passing mode;
passing the first read current (32) in the second bit line (BL2) and the first MTJ element (10);
passing the second read current (34) in the third bit line (BL3) and the second MTJ element (11);
measuring a difference between the first read current (32) and the second read current (34) when the first and second read currents (32, 34) flow through the first and second MTJ elements (10, 11), respectively; and
determining the magnetic state of the first and second MTJ elements (10, 11) from said difference.
